# EUROPEAN PATENT SPECIFICATION

(11) **EP 2 946 412 B1**
(45) Date of publication and mention of the grant of the patent: **19.06.2019**
(21) Application number: 13872103.0
(22) Date of filing: 18.01.2013
(51) Int. Cl.: H01L 35/30, H01L 35/32

(54) **COMBINED CERAMIC MATRIX COMPOSITE AND THERMOELECTRIC STRUCTURE FOR ELECTRIC POWER GENERATION**
KOMBINIERTER KERAMIKMATRIXVERBUNDSTOFF UND THERMOELEKTRISCHE STROMERZEUGUNGSSTRUKTUR
COMPOSITE À MATRICE CÉRAMIQUE ET STRUCTURE THERMOÉLECTRIQUE COMBINÉS POUR LA PRODUCTION D'ÉNERGIE ÉLECTRIQUE

(43) Date of publication of application: 25.11.2015
(73) Proprietor: United Technologies Corporation, Farmington, CT 06032 (US)
(72) Inventor: JARMON, David C., Hendersonsville North Carolina 28739 (US)
(74) Representative: Dehns
(86) International application number: PCT/US2013/022144
(87) International publication number: WO 2014/113018

(56) References cited:
- US-A- 5 228 923
- US-A1- 2005 172 993
- US-A1- 2010 116 307
- US-A1- 2010 242 437
- US-A1- 2012 118 344
- US-A1- 2012 174 956
- US-B1- 6 367 261
- US-B2- 6 951 456
- US-B2- 7 641 440
- US-B2- 8 127 555

## Description

### BACKGROUND

The present invention relates to passive conversion of waste heat in a hot gas flow path into electrical energy.

Waste heat in thermal power generation systems can be converted into electrical energy using thermoelectric devices placed across temperature gradients in selected regions of the structures provided the thermal profiles are manageable and the regions physically accessible. Thermoelectric devices are solid state electronic devices that have a near infinite shelf life, are maintenance free, and contain little or no hazardous materials. In some situations such as gas turbine powered air and sea craft, thermoelectric power generation can be considered an added source of energy. In other situations such as hypersonic vehicle (e.g., scram jet) applications, thermoelectric power generation using the thermal gradients adjacent to a hot gas path may be critical to mission success. US 2005/0172993 A1 discloses a thermoelectric generator for an internal combustion engine.

Hypersonic vehicle transportation offers potential for future commercial and military application decreasing time to target thereby extending global reach. These vehicles are anticipated to be powered by scram jet (supersonic combustion ram jet) engines during the hypersonic portion of flight. The structure which forms the hypersonic gas flow path in a scram jet engine is referred to as a heat exchanger (HEX) in the art. Hypersonic flow paths are fuel cooled since air cooling is not practical in a hypersonic environment. Fuel cooling also serves to preheat the fuel which adds energy to the fuel for combustion. Scram jet engines have no rotating mechanical elements which, in a conventional jet engine, are used to generate accessory power required for fuel pumps and onboard electrical systems. Hypersonic vehicles are currently envisioned to require either auxiliary power units (APUs) and/or batteries to meet vehicle power requirements. Both solutions add onboard weight, volume and system complexity. In addition, they require periodic maintenance and commonly contain hazardous materials, such as acids or hydrazine.

Other propulsion and APU requirements associated with hot gas streams and other sources of extraordinary thermal gradients can benefit from passive thermoelectric power generation. Examples include next generation turbine related
propulsion and power generation systems where efficiency scales directly as the absolute temperature differential between input and exhaust working fluids.

### SUMMARY

An electrical power generation system is provided according to claim 1 and is configured to surround a hot gas path of an energy source to provide passive thermoelectric energy. The system includes a ceramic hot face liner coated with a thermally conducting material capable of being shaped to form mounting surfaces that conform to inner surfaces of thermoelectric elements attached to the liner to maximize thermal communication between the elements and the hot face liner. Cooling channels attached to outer surfaces of the thermoelectric elements result in a thermal gradient across the elements and resulting thermoelectric power generation. Clamps that apply clamping forces to maintain physical and thermal contact between all elements and the ceramic liner result in improved power generation. A reaction barrier layer is provided between the conformal layer and the thermoelectric elements.

A method to form an electric power generation system is provided according to claim 5 and consists of first fabricating a ceramic hot gas path liner. A layer of thermally conducting material is then deposited on the liner. Flat surfaces are formed on the layer that allow good thermal and physical contact between the thermally conducting layer and flat inner surfaces of thermoelectric elements mounted on the layer. Metal cooling ducts mounted on flat outer surfaces of the thermoelectric elements provide good thermal and physical contact between the thermoelectric elements and the cooling ducts. A compressive clamping force is then applied to the cooling ducts, thermoelectric elements, and hot gas path liner to maximize the thermal gradient across the thermoelectric elements
and resulting thermoelectric power generation of the system. A reaction barrier layer is formed between the conformal layer and the thermoelectric elements.

### BRIEF DESCRIPTION OF THE DRAWINGS

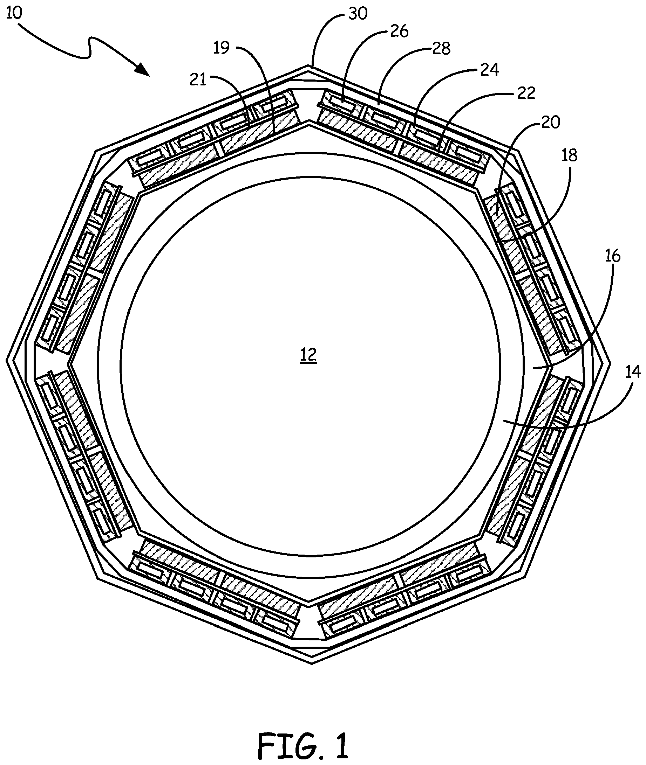

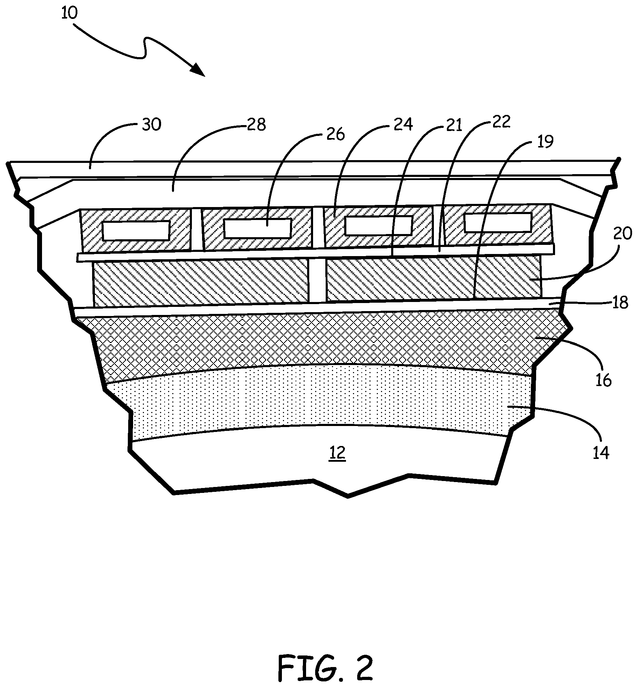

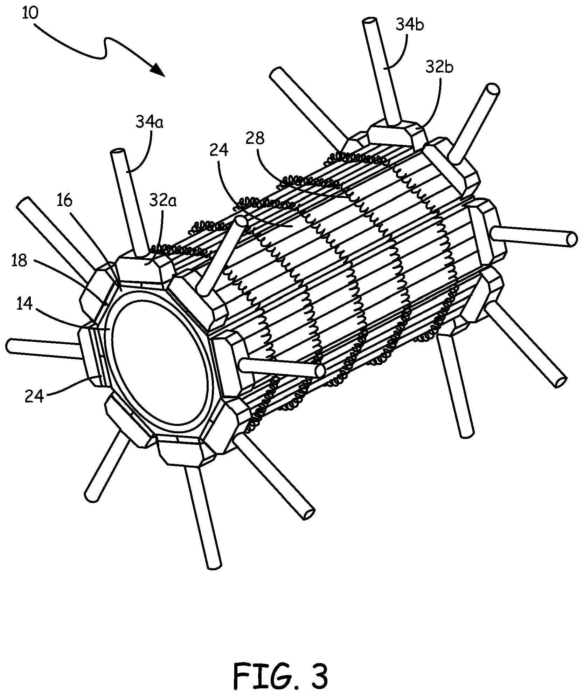

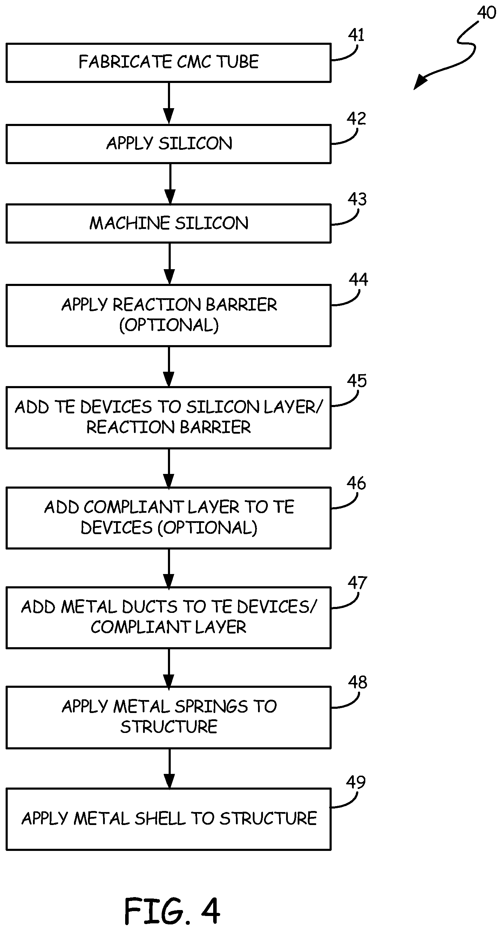

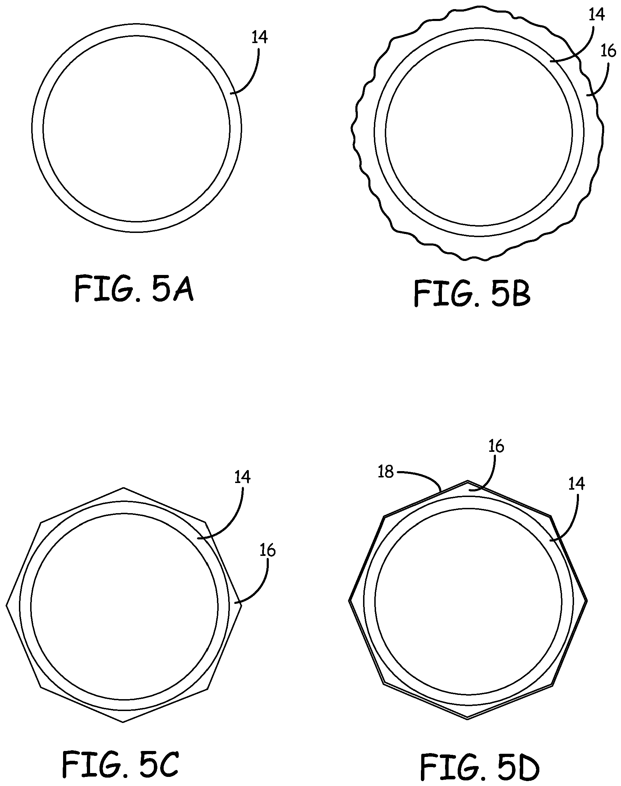

FIG. 1 is a schematic cross-section of an electrical power generation system according to the present invention.FIG. 2 is an expanded cross-sectional view of a portion of the system in FIG. 1.FIG. 3 is a perspective view of a complete power generation module according to the present invention.FIG. 4 is a diagram of a method for forming an electrical power generation system according to the present invention.FIGS. 5A-5I illustrate an embodiment of the method of forming an electrical power generation system according to the present invention.

### DETAILED DESCRIPTION

The present invention is a passive thermoelectric energy generation system associated with extremely hot gas path generation and control such as that found in scram jet or other hypersonic vehicle propulsion systems. It should be understood that other propulsion and energy generation systems such as rocket based, turbine based or fusion based systems may benefit therefrom.

A schematic cross-section of an embodiment of the invention is shown in FIG. 1. Thermoelectric power generation structure 10 is a cylindrical enclosure surrounding hot gas path 12 of a propulsion or other power generating system. Temperatures in the gas path can exceed 1100°C. A larger cross-section of a portion of structure 10 is shown in FIG. 2 for clarity.

The structure comprises hot face liner 14 capable of withstanding the thermal, chemical and mechanical degradation afforded by a high velocity thermal gas stream impinging on hot face liner 14 during operation. Hot face liner 14 is encased in thermally conductive, shaped layer 16. Shaped layer 16 is a necessary and central feature of the invention and will be described in detail. Layer 18 on thermally conductive shaped layer 16 acts as a reaction barrier. Thermoelectric (TE) element 20 may be mounted directly on thermally conductive shaped layer 16 or on layer 18 such that inner surface 19 of TE element 20 is in direct thermal and physical contact with thermally conductive layer 16 or layer 18. As discussed later, TE element 20 is the source of the power of thermoelectric power generation structure 10.

Optional compliant layer 22 may be mounted on thermoelectric element 20 such that outer surface 21 of TE element 20 is in direct thermal and physical contact with compliant layer 22. Metal cooling ducts 24 may be mounted on compliant layer 22 or directly on outer surface 21 of TE element 20 and may carry coolant fluid 26 to extract heat from outer surface 21 of TE element 20. Metal cooling ducts 24, TE elements 20 and intervening optional compliant layers 22 and reaction barrier layer 18 are compressibly forced (i.e. clamped) against each other and to conductive shaped interface 16 by canted coil spring 28. Metal shell 30 encloses the aforementioned components and provides a structure for canted coil spring 28 to react against and to form thermoelectric power generation structure 10. In addition, metal shell 30 can provide a controlled atmosphere within thermoelectric power generation structure 10.

Individual components of thermoelectric power generation structure 10 will now be described in more detail.

For optimum resistance to the potentially hypersonic, erosive high temperature gas path in thermoelectric power generation structure 10, hot face liner 14 is preferably a ceramic material, more preferably a ceramic matrix composite (CMC) material. Hot face liner 14 may be formed from one or more of carbon fiber reinforced silicon carbide (C/SiC), carbon fiber reinforced carbon (C/C), silicon carbide fiber reinforced silicon carbide (SiC/SiC), silicon melt infiltrated SiC fiber reinforced SiC (MI SiC/SiC), or other suitable ceramic or ceramic matrix composite materials known in the art.

It is recognized that maximum thermoelectric output of the invention depends on the temperature difference between the hot and cold junctions of the thermoelectric elements in thermoelectric power generation structure 10. Establishing good thermal connections between the thermoelectric elements and the ceramic hot face liner to maximize the hot junction temperature of TE element 20 is a key design issue. Thermoelectric elements with flat mating surfaces are readily available but do not physically interface well with curved surfaces of cylindrical components such as ceramic matrix composite hot face gas path channels. In commonly owned Patent Application No. US 2011/0219775, methods to improve the surface finish of ceramic matrix composite materials by depositing a hardenable, machinable material on the surface of the ceramic matrix composite were disclosed. In one embodiment, thermally conductive silicon was deposited as a hardenable machinable material. In the present invention, silicon may be deposited as thermally conductive shaped layer 16 on ceramic matrix composite hot face liner 14. Machining flats on thermally conductive shaped layer 16 then allows flat thermoelectric elements 20 to be easily attached to ceramic matrix composite liner 14 with a close fitting, thermally conductive interface. Although not limited to silicon alone for the present application, the material is well suited as a thermal interface between gas path 12 and thermoelectric elements 20 because of its 1410°C melting point and excellent thermal conductivity of 84W/m-K, where W, m, and K designate watt, meter, and degree Kelvin, respectively.

Reaction barrier layer 18 between thermally conductive shaped layer 16 and thermoelectric elements 20 may be required to manage the thermal conductivity between the hot gas path and the thermoelectric elements. If increased thermal conductivity is desired, for instance, a layer of silicon carbide with a thermal
conductivity of 40W/m·K may be deposited. If lower thermal conductivity is a goal, a layer of colloidal silica with a thermal conductivity of 2 W/m·K may be deposited.

Thermoelectric element 20 may be any device known in the art that can withstand the operating environment of the present invention. Examples include, but are not limited to, lead telluride/tellurium-antimony-germanium-silver (PbTe/TAGS) device, silicon germanium (SiGe) device and others known in the art..

Metal cooling ducts 24 comprise a heat exchanger connected to outer surfaces 21 of TE elements 20 wherein fluid 26 carries heat away from the backside of TE elements 20 and increases the temperature gradient between the hot and cold TE junctions on element 20 thereby increasing the TE energy output.

Optional compliant layer 22 acts as an interface between metal cooling ducts 24 and TE elements 20. In operation, compliant layer 22 deforms and increases thermal and physical contact between outer surfaces 21 of TE elements 20 and metal cooling ducts 24. Compliant layer 22 needs to have high thermal conductivity and deformability to maximize thermal communication between TE elements 20 and metal cooling ducts 24. Compliant layer 22 may be oxygen free high conductivity copper (OFHC) in the dead soft annealed condition. "Dead soft annealed" is a term describing a fully annealed material with typically low hardness. Dead soft annealed OFHC copper may have a hardness less than 45 Rockwell F. The thermal conductivity of OFHC copper, as noted earlier, is 391W/m·K.

Canted metal springs 28 are one embodiment of the invention that applies a compressive clamping force on structure 10 to maximize thermal and physical contact across all mating interfaces in thermoelectric power generation structure 10. The constant clamping load over a large spring displacement makes canted springs a good candidate for this application. For optimal pressure control, the canted coil springs react against metal shell 30 or a metal strap. High temperature superalloy springs are well known in the art and available. Other clamping mechanisms known in the art are also possible, such as coil springs and compression springs.

Protective metal shell 30 surrounds the structure, restrains the canted springs and provides atmosphere control within thermoelectric power generation structure 10, if necessary.

A perspective view of a test module of the enclosure without the exterior shell is shown in FIG. 3 with each separate component marked accordingly. Coolant inlet and outlet manifolds 32a and 32b and their respective tubes 34a and 34b that supply fluid coolant to metal cooling ducts 24 are also shown.

FIG. 4 is method 40 for forming thermoelectric power generation system 10 according to an embodiment of the present invention.

FIGS. 5A-5I illustrate an embodiment of method 40 for the assembly of thermoelectric power generation system 10 with each component numbered accordingly.

In first step 41, a ceramic matrix composite (CMC) tube to contain a hot gas path is fabricated to form liner 14 (FIG. 5A). The CMC tube containment structure may be fabricated by procedures such as chemical vapor infiltration (CVI), polymer impregnation and pyrolysis (PIP), and other procedures known in the art. While a tube structure is a feature of the gas path enclosure of the present embodiment, the invention is not limited to tubes and other enclosures such as flat and curved panels are possible.

In step 42, thermally conductive shaped layer 16 is formed (FIG. 5B). In an embodiment, thermally conductive shaped layer 16 is formed by depositing silicon on CMC liner 14. Silicon may be deposited by air plasma spray or other means known in the art. Silicon is well suited as a thermally conductive shaped layer because of its high thermal conductivity (84 W/m-K), high melting point (1410°C), chemical stability and machinability. Silicon has also demonstrated excellent bonding and chemical compatibility with SiC based CMCs, such as C/ SiC, SiC/SiC, C/C and MI SiC/SiC.

In step 43, flat surfaces are formed on thermally conductive shaped layer 16 (FIG. 5C). A preferred method of shaping is diamond grinding.

In step 44, reaction barrier layer 18 may then be applied to thermally conductive shaped layer 16 (FIG. 5D). The material for reaction barrier layer 18 depends on the thermal conductivity required of the layer. If a high thermal conductivity reaction barrier is desired, a thin vapor deposited silicon carbide layer may be a candidate. If a low thermal conductivity reaction barrier is desired, a colloidal silica layer may be a candidate.

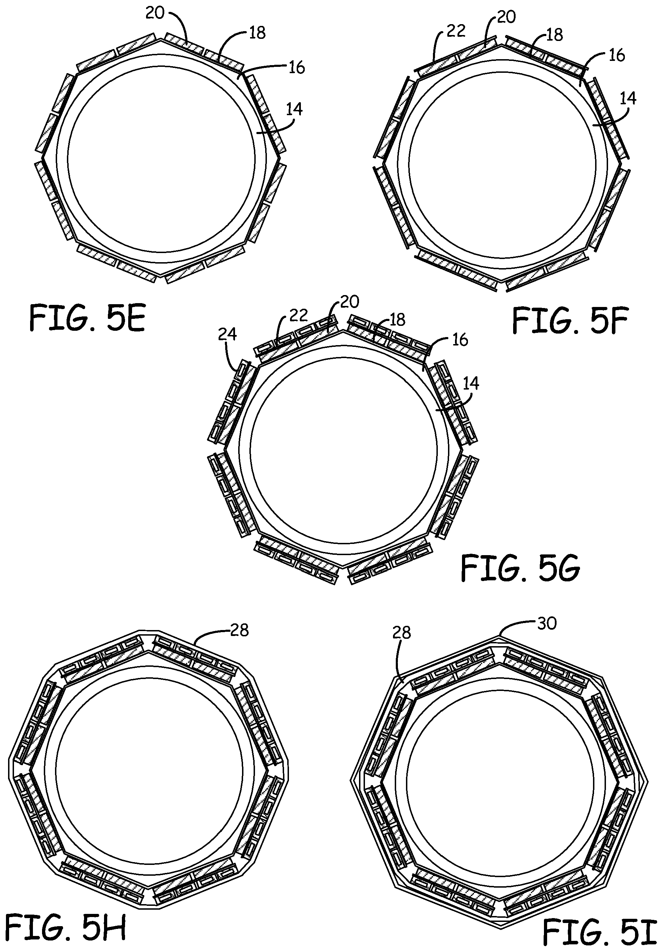

In step 45, thermoelectric elements 20 are then mounted on thermally conductive shaped layer 16 or reaction barrier layer 18 such that inner surfaces 19 of TE elements 20 are in direct thermal and physical contact with shaped layer 16 or reaction barrier layer 18 (FIG 5E).

In step 46, optional compliant layer 22 is added to thermoelectric elements 20 (FIG. 5F). This is to enhance thermal and physical contact between thermoelectric
elements 20 and metal cooling ducts 24 to be added in the next step to maximize the thermal gradient across thermoelectric elements 20 by thermal conduction through outer surface 21. An optimum candidate material for compliant layer 22 is oxygen free high conductivity copper (OFHC) in the dead soft mechanical condition. OFHC copper has a thermal conductivity of 391 W/m·K. In the dead soft condition, OFHC copper conforms well to the shape of the thermoelectric elements and to metal cooling ducts 24 to be added in the next step.

In step 47, metal cooling ducts 24 (or heat exchangers, HEX, as they are known in the art), are then added to thermoelectric elements 20 or optional complaint layer 22 (FIG. 5G). The HEX tubes 24 connect to inlet and outlet manifolds 32a and 32b and inlet and outlet coolant supply tubes 34a and 34b on both ends as shown in FIG. 3. The HEX tubes carry a coolant to maximize the thermal gradient in thermoelectric elements 20.

In step 48, metal springs 28 are added to metal cooling ducts (HEX tubes) 24 to clamp the overall assembly in compression against ceramic matrix composite hot face liner 14 (FIG. 5H). Canted metal coil springs 28 are ideal for this application because they have a relatively constant clamping force over a large displacement. They can be fabricated from a wide range of high temperature metals including Inconel and stainless steel.

In step 49, metal shell 30 is added to the structure to form an outer enclosure and to maintain canted coil springs 28 in a compressed form (FIG. 5I). Enclosure 30 may also be used to maintain a protective atmosphere around thermoelectric power generation system 10.

It should be noted that an additional protective ceramic coating may be applied to the inside of ceramic matrix composite liner 14 as added protection against oxidation, moisture, erosion, etc. in the hot gas stream. Coatings have been developed that are specific to different types of ceramic matrix composites and atmospheres. Candidate coatings are the subject of commonly owned Patent No. US 7,951,459.

The present invention is a unique structure that combines the previously noted commonly owned U.S. 2011/0219775
patent application as well as commonly owned U.S. 2007/0018038 and U.S. 2010/0242437 patent applications as well as other inventive concepts into a single structure.

Addition of a thermally conductive, machinable silicon layer on a fiber reinforced ceramic matrix composite (CMC) gas path liner enabled flat mating surfaces of thermoelectric elements to be mounted on flat surfaces machined on the liner to provide maximum thermal conductivity between the silicon layer and the thermoelectric elements. This maximizes the temperature of the thermoelectric hot junction and resulting thermoelectric power.

Silicon has excellent chemical compatibility with SiC, C, SiNC and other CMC components and forms strong bonds when coated on these materials. The material is readily machined to high tolerances and has a thermal conductivity of 84W/m.K and 1410°C melting point.

Providing a machinable interface on fiber reinforced ceramic matrix composites (CMC) allows CMC components to be shaped by machining without rupturing fibers in the ceramic matrix.

Silicon acts as a heat spreader between the CMC hot face liner and thermoelectric devices. A more uniform temperature across the TE element contact area increases the power output of the element.

The structure is able to accommodate differential thermal expansion between components under both steady state and transient operating conditions thereby minimizing thermally induced stresses.

Clamping devices such as canted springs apply controllable loading at pressures that will not damage the TE elements.

Compliant layers between the TE elements and adjacent components and canted springs allow looser dimensional tolerances to be adapted in complicated structures such as thermoelectric power generation structure 10 of the present invention.

Fasteners and hardware have been eliminated from prior art designs that have results in an areal density savings of about 4Kg/m2.

Atmosphere control is provided by locating thermoelectric elements between the CMC hot face liner and a continuous metal shell.

While the invention has been described with reference to an exemplary embodiment(s), it will be understood by those skilled in the art that various changes may be made without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. An electric power generation system (10) comprising:
a ceramic liner (14) of a hot gas path (12) enclosure;
a thermally conductive conformal layer (16) on the liner (14) shaped to provide an inner surface that conforms to the liner (14) and to provide an outer surface that forms a plurality of flat mounting surfaces;
thermoelectric elements (20) mounted on the flat mounting surfaces of the thermally conductive conformal layer (16) with an inner surface (19) of each thermoelectric element (20) adjacent one of the mounting surfaces of the thermally conductive conformal layer (16);
cooling channels (24) connected to an outer surface (21) of the thermoelectric elements (20);
a clamp (28) that surrounds the ceramic liner (14), thermally conductive conformal layer (28), thermoelectric elements (20), and cooling channels (24) for applying a compressive clamping force to maintain thermal and physical contact between the ceramic liner (14), thermally conductive conformal layer (16), thermoelectric elements (20) and cooling channels (24); **characterised by** comprising
a reaction barrier layer (18) between the conformal layer (16) and the thermoelectric elements (20).

2. The system (10) of claim 1, wherein the thermally conductive conformal layer (16) comprises silicon.

3. The system (10) of claims 1 or 2, further comprising a compliant layer (22) between the thermoelectric elements (20) and the cooling channels (24).

4. The system (10) of any preceding claim, further comprising an outer protective metal shell (30).

5. A method comprising:
fabricating a ceramic hot gas path liner (14);
depositing a thermally conducting layer (16) on the liner (14) that has an inner surface that conforms to the liner (14);
forming flat mounting surfaces on an outer surface of the thermally conducting layer (16);
mounting thermoelectric elements (20) to the flat mounting surfaces of the thermally conducting layer (16) such that an inner surface (12) of the thermoelectric elements (20) is in direct thermal and physical contact with the flat mounting surfaces of the thermally conducting layer (16);
adding metal cooling ducts (24) to the outer surface (21) of the thermoelectric elements (20) such that the surfaces of the metal cooling ducts (24) are in direct thermal and physical contact with the outer surfaces (21) of the thermoelectric elements (20);
applying a compressive clamping force to the metal cooling ducts (24), thermoelectric elements (20), thermally conducting layer (16), and hot gas path liner (14) to maintain thermal and physical contact between them that creates a thermal gradient in the thermoelectric elements (20) and forms
an electric power generation system (10); **characterised by** forming a reaction barrier layer (18) between the conformal layer (16) and the thermoelectric elements (20).

6. The method of claim 5, wherein the thermally conducting material comprises silicon.

7. The method of claims 5 or 6, further comprising forming a compliant layer (22) between the thermoelectric elements (20) and the cooling channels (24).

8. The method of any of claims 5 to 7, further comprising positioning an outer protective metal shell (30) around the electric power generation system (10).

9. The method or system (10) of any preceding claim, wherein the ceramic liner (14) comprises a ceramic matrix composite (CMC).

10. The method or system (10) of any preceding claim, wherein the ceramic matrix composite comprises carbon fiber reinforced silicon carbide (C/SiC), carbon fiber reinforced carbon (C/ C), silicon carbide fiber reinforced silicon carbide (SiC/SiC), silicon melt infiltrated silicon carbide fiber reinforced silicon carbide (MI SiC/SiC), and/or mixtures thereof.

11. The method or system (10) of any preceding claim, wherein the cooling channels (24) comprise metal channels carrying a fluid coolant (26).

12. The method or system (10) of any preceding claim, wherein the clamp (28) to maintain thermal and physical contact between the components comprises springs surrounding the enclosure, thereby putting the components under compression.

13. The method or system (10) of claim 12, wherein the springs are canted coil springs.

## Patentansprüche

1. Stromerzeugungssystem (10), das Folgendes umfasst:
eine Keramikauskleidung (14) eines Gehäuses eines Warmgasverlaufs (12);
eine wärmeleitfähige konforme Schicht (16) an der Auskleidung (14), die dazu geformt ist, eine innere Fläche bereitzustellen, die der Auskleidung (14) entspricht, und eine äußere Fläche bereitzustellen, die eine Vielzahl von flachen Montageflächen bildet;
thermoelektrische Elemente (20), die an den flachen Montageflächen der wärmeleitfähigen konformen Flächen (16) montiert sind, wobei eine innere Fläche (19) von jedem thermoelektrischen Element (20) an die Montageflächen der wärmeleitfähigen konformen Schicht (16) grenzt;
Kühlkanäle (24), die mit einer äußeren Fläche (21) der thermoelektrischen Elemente (20) verbunden sind;
eine Klammer (28), welche die keramische Auskleidung (14), die wärmeleitfähige konforme Schicht (28), die thermoelektrischen Elemente (20) und die Kühlkanäle (24) zum Anwenden einer komprimierenden Klemmkraft umgibt, um den thermischen und physischen Kontakt zwischen der Keramikauskleidung (14), der wärmeleitfähigen konformen Schicht (16), den thermoelektrischen Elementen (20) und den Kühlkanälen (24) beizubehalten; **dadurch gekennzeichnet, dass** sie eine Reaktionssperrschicht (18) zwischen der konformen Schicht (16) und den thermoelektrischen Elementen (20) umfasst.

2. System (10) nach Anspruch 1, wobei die wärmeleitfähige konforme Schicht (16) Silicium umfasst.

3. System (10) nach den Ansprüchen 1 oder 2, das ferner eine nachgiebige Schicht (22) zwischen den thermoelektrischen Elementen (20) und den Kühlkanälen (24) umfasst.

4. System (10) nach einem der vorhergehenden Ansprüche, das ferner eine äußere Schutzhülle aus Metall (30) umfasst.

5. Verfahren, das Folgendes umfasst:
Herstellen einer Keramikwarmgasverlaufsauskleidung (14);
Aufbringen einer wärmeleitfähigen Schicht (16) auf die Auskleidung (14), die eine innere Fläche aufweist, die der Auskleidung (14) entspricht;
Bilden von flachen Montageflächen auf einer äußeren Fläche der wärmeleitfähigen Schicht (16);
Montieren von thermoelektrischen Elementen (20) auf den flachen Montageflächen der wärmeleitfähigen Schicht (16), sodass eine innere Fläche (12) der thermoelektrischen Elemente (20) in direktem thermischen und physischen Kontakt mit den flachen Montageflächen der wärmeleitfähigen Schicht (16) steht;
Hinzufügen von Metallkühlkanälen (24) zu der äußeren Fläche (21) der thermoelektrischen Elemente (20), sodass die Flächen der Metallkühlkanäle (24) in direktem thermischen und physischen Kontakt mit den äußeren Flächen (21) der thermoelektrischen Elemente (20) stehen;
Anwenden einer komprimierenden Klemmkraft auf die Metallkühlkanäle (24), die thermoelektrischen Elemente (20), die wärmeleitfähigen Schichten (16) und die Warmgasverlaufsauskleidungen (14), um den thermischen und physischen Kontakt zwischen diesen beizubehalten, der einen thermischen Gradienten in den thermoelektrischen Elementen (20) erzeugt und ein elektrisches Leistungserzeugungssystem (10) bildet; **gekennzeichnet durch** Bilden einer Reaktionssperrschicht (18) zwischen der konformen Schicht (16) und den thermoelektrischen Elementen (20).

6. Verfahren nach Anspruch 5, wobei das wärmeleitfähige Material Silicium umfasst.

7. Verfahren nach einem der Ansprüche 5 oder 6, das ferner Bilden einer nachgiebigen Schicht (22) zwischen den thermoelektrischen Elementen (20) und den Kühlkanälen (24) umfasst.

8. Verfahren nach einem der Ansprüche 5 bis 7, das ferner Positionieren einer äußeren Schutzhülle aus Metall (30) um das elektrische Leistungserzeugungssystem (10) umfasst.

9. Verfahren oder System (10) nach einem der vorhergehenden Ansprüche, wobei die Keramikauskleidung (14) einen Keramikmatrixverbundstoff (ceramic matrix composite - CMC) umfasst.

10. Verfahren oder System (10) nach einem der vorhergehenden Ansprüche, wobei der Keramikmatrixverbundstoff kohlenstofffaserverstärktes Siliciumcarbid (C/SiC), kohlenstofffaserverstärkten Kohlenstoff (C/C), siliciumcarbidfaserverstärktes Siliciumcarbid (SiC/SiC), siliciumschmelzinfiltriertes siliciumcarbidfaserverstärktes Siliciumcarbid (MI SiC/SiC) und/oder Mischungen davon umfasst.

11. Verfahren oder System (10) nach einem der vorhergehenden Ansprüche, wobei die Kühlkanäle (24) Metallkanäle umfassen, die ein Flüssigkeitskältemittel (26) tragen.

12. Verfahren oder System (10) nach einem der vorhergehenden Ansprüche, wobei die Klammer (28) zum Beibehalten vom thermischen oder physischen Kontakt zwischen den Komponenten Federn umfasst, die das Gehäuse umgeben, wodurch die Komponenten unter Komprimierung gesetzt werden.

13. Verfahren oder System (10) nach Anspruch 12, wobei die Federn geneigte Spulenfedern sind.

## Revendications

1. Système de production d'énergie électrique (10) comprenant :
un revêtement céramique (14) d'une enceinte à passage de gaz chaud (12) ;
une couche conforme thermiquement conductrice (16) sur le revêtement (14) formée pour fournir une surface intérieure qui s'adapte au revêtement (14) et pour fournir une surface extérieure qui forme une pluralité de surfaces de montage planes ;
des éléments thermoélectriques (20) montés sur les surfaces de montage planes de la couche conforme thermiquement conductrice (16) avec une surface intérieure (19) de chaque élément thermoélectrique (20) adjacente à l'une des surfaces de montage de la couche conforme thermiquement conductrice (16) ;
des canaux de refroidissement (24) reliés à une surface extérieure (21) des éléments thermoélectriques (20) ;
une pince (28) qui entoure le revêtement céramique (14), la couche conforme thermiquement conductrice (28), les éléments thermoélectriques (20) et les canaux de refroidissement (24) pour appliquer une force de serrage par compression afin de maintenir le contact thermique et physique entre le revêtement céramique (14), la couche conforme thermiquement conductrice (16), les éléments thermoélectriques (20) et les canaux de refroidissement (24) ; **caractérisé en ce qu'**il comprend :
une couche de barrière de réaction (18) entre la couche conforme (16) et les éléments thermoélectriques (20).

2. Système (10) selon la revendication 1, dans lequel la couche conforme thermiquement conductrice (16) comprend du silicium.

3. Système (10) selon les revendications 1 ou 2, comprenant en outre une couche souple (22) entre les éléments thermoélectriques (20) et les canaux de refroidissement (24).

4. Système (10) selon une quelconque revendication précédente, comprenant en outre une enveloppe métallique externe de protection (30).

5. Procédé comprenant :
la fabrication d'un revêtement céramique de passage de gaz chaud (14) ;
le dépôt d'une couche thermiquement conductrice (16) sur le revêtement (14) qui présente une surface intérieure qui s'adapte au revêtement (14) ;
la formation de surfaces de montage planes sur une surface extérieure de la couche thermiquement conductrice (16) ;
le montage d'éléments thermoélectriques (20) sur les surfaces de montage planes de la couche thermiquement conductrice (16) de sorte qu'une surface intérieure (12) des éléments thermoélectriques (20) est en contact thermique et physique direct avec les surfaces de montage planes de la couche thermiquement conductrice (16) ;
l'ajout de conduites métalliques de refroidissement (24) sur la surface extérieure (21) des éléments thermoélectriques (20) de sorte que les surfaces des conduites métalliques de refroidissement (24) sont en contact thermique et physique direct avec les surfaces extérieures (21) des éléments thermoélectriques (20) ;
l'application d'une force de serrage par compression sur les conduites métalliques de refroidissement (24), les éléments thermoélectriques (20), les couches thermiquement conductrices (16) et le revêtement de passage de gaz chaud (14) afin de maintenir le contact thermique et physique entre eux qui crée un gradient thermique dans les éléments thermoélectriques (20) et forme un système de production d'énergie électrique (10) ;
**caractérisé par** la formation d'une couche de barrière de réaction (18) entre la couche conforme (16) et les éléments thermoélectriques (20).

6. Procédé selon la revendication 5, dans lequel la matière électriquement conductrice comprend du silicium.

7. Procédé selon les revendications 5 ou 6, comprenant en outre la formation d'une couche conforme (22) entre les éléments thermoélectriques (20) et les canaux de refroidissement (24).

8. Procédé selon l'une quelconque des revendications 5 à 7, comprenant en outre le positionnement d'une enveloppe métallique externe de protection (30) autour du système de production d'énergie électrique (10).

9. Procédé ou système (10) selon une quelconque revendication précédente, dans lequel le revêtement céramique (14) comprend un composite à matrice céramique (CMC).

10. Procédé et système (10) selon une quelconque revendication précédente, dans lequel le composite à matrice céramique comprend un carbure de silicium renforcé par des fibres de carbone (C/SiC), un carbone renforcé par des fibres de carbone (C/C), un carbure de silicium renforcé par des fibres de carbure de silicium (SiC/SiC), un carbure de silicium renforcé par des fibres de carbure de silicium à infiltration par fusion de silicium (MI SiC/SiC) et/ou des mélanges de ceux-ci.

11. Procédé ou système (10) selon une quelconque revendication précédente, dans lequel les canaux de refroidissement (24) comprennent des canaux métalliques transportant un réfrigérant de fluide (26).

12. Procédé ou système (10) selon une quelconque revendication précédente, dans lequel la pince (28) pour maintenir le contact thermique et physique entre les composants comprend des ressorts entourant l'enceinte, mettant ainsi les composants sous compression.

13. Procédé ou système (10) selon la revendication 12, dans lequel les ressorts sont des ressorts hélicoïdaux inclinés.
